(19) Europäisches Patentamt

European Patent Office

Office européen des brevets

(11) Publication number: **0 206 508 B1**

(12) **EUROPEAN PATENT SPECIFICATION**

(45) Date of publication of patent specification: **06.11.91**  (51) Int. Cl.⁵: **G06K 11/06**

(21) Application number: **86303752.9**

(22) Date of filing: **16.05.86**

(54) **Digitizer for a computer.**

(30) Priority: **17.05.85 JP 105399/85**

(43) Date of publication of application:
**30.12.86 Bulletin 86/52**

(45) Publication of the grant of the patent:
**06.11.91 Bulletin 91/45**

(84) Designated Contracting States:
**DE GB**

(56) References cited:
**EP-A- 0 172 657**
**GB-A- 2 093 299**

(73) Proprietor: **SEIKO INSTRUMENTS INC.**
**31-1, Kameido 6-chome Koto-ku**
**Tokyo 136(JP)**

(72) Inventor: **Morita, Yoshiyuki c/o Seiko Instr.&**
**Electr. Ltd.**
**31-1, Kameido 6-chome Koto-ku**
**Tokyo(JP)**

(74) Representative: **Miller, Joseph et al**
**J. MILLER & CO. Lincoln House 296-302 High**
**Holborn**
**London WC1V 7JH(GB)**

EP 0 206 508 B1

## Description

This invention relates to digitizers, for example, serving as input devices of digital apparatus such as computers, and more particularly to electromagnetic induction type digitizers using phase inversion detection.

Digitizers are disclosed in U.S. Patent Specifications Nos. 4,368,351 and 4,206,314.

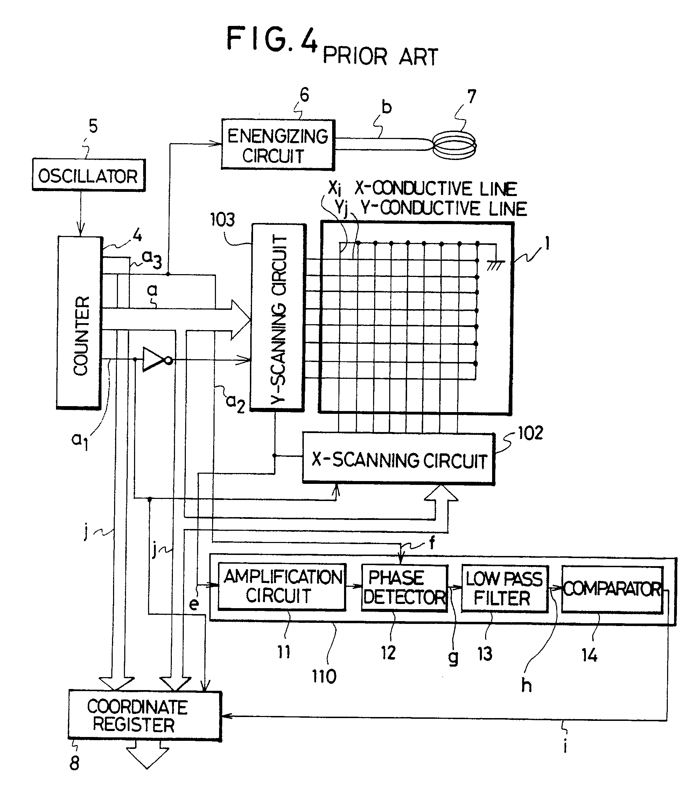

A conventional digitizer shown in Figure 4 has a tablet 1 serving as a write-in plate or substrate for determining the position of a winding coil 7. The tablet 1 carries X-conductive lines and Y-conductive lines. Conductive lines $X_i$ are arranged perpendicular to the conductive lines $Y_j$ and the distance between adjacent conductive lines $X_i$ and between adjacent conductive lines $Y_j$ is 6.4 mm, respectively. One end of each of the conductive lines $X_i$ and $Y_j$ is grounded, and the other end of each conductive line $X_i$ is connected to an X-scanning circuit 102 and the other end of each conductive line $Y_j$ is connected to a Y-scanning circuit 103.

The X-scanning circuit 102 and the Y-scanning circuit 103 are analogue switching circuits which select one of the X-conductive lines and one of the Y-conductive lines respectively in response to a conductive line select address signal a. The X-scanning circuit 102 and the Y-scanning circuit 103 have their outputs connected to an input of a process circuit 110. A multi-stage binary counter 4 counts signals from an oscillater 5. Certain bits of the count value function as the conductive lines select address signal a inputted to the X-scanning circuit 102 and the Y-scanning circuit 103.

As shown in Figure 4, a bit signal $a_1$ adjacent to the conductive line select address signal is used to select the X-scanning circuit 102 and the Y-scanning circuit 103 alternately, that is, the operation for selecting the X-conductive lines $X_i$ and the operation of selecting the Y-conductive lines $Y_j$ are conducted alternately.

The following description will be made without distinguishing X-coordinate from Y-coordinate since the process for solving the value of the X-coordinate is the same as that for the Y-coordinate.

A bit signal $a_2$, lower than the conductive line select address signal a is provided to an energizing circuit 6 to energize the winding coil 7, and the signal process circuit 110 as a reference signal f in order to effect phase detection in an induction signal e from the scanning circuit.

The winding coil 7 is energized by an energizing signal b in response to the bit signal $a_2$ and produces a magnetic field so that the induction signal e is produced on the conductive line by virtue of the electro-magnetic coupling.

Moreover, a lower bit signal $a_3$ including the bit signal $a_2$ corresponding to the count of the counter 4 is used to measure the position of the winding coil between the conductive lines and a detailed explanation of this will be given later.

The signal processing circuit 110 is connected to the scanning circuit which receives the induction signal e induced on the conductive line. The signal processing circuit 110 includes an amplification circuit 11, a phase detector 12, a low pass filter 13 and a comparator 14.

Although a detailed explanation will be given later, a load signal i is outputted at a time when the position of the winding coil 7 above the tablet 1 is detected.

A coordinate register 8 is loaded with a count signal j from the counter 4 in response to the load signal i so that the coordinate register 8 holds the count signal as the coordinate value.

Next, the operation of the conventional digitizer of Figure 4 will be described with reference to Figures 5 to 8 and particularly by the timing diagram of Figure 7. The conductive line select address signal a is applied to the scanning circuit every given period as shown in Figure 7 and the energizing signal b of one-half period of the conductive line select address signal is applied to the winding coil 7 so that the induction signal e induced on each conductive line is inputted to the signal process circuit 110 in turn.

Comparing the energizing signal b with the induction signal e, these signals are coincident with each other in phase in the section between A and B and are in inverse phase in the section between B and C.

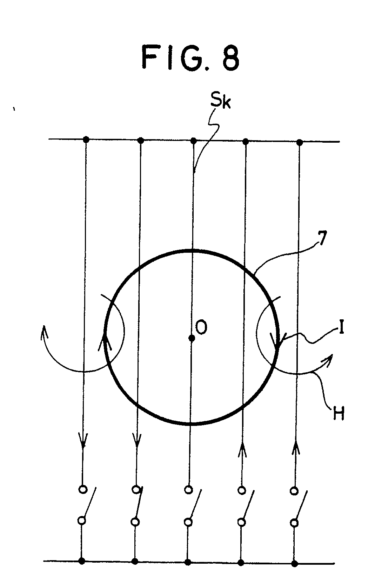

As shown in Figure 8, this is because the direction of the induction current is inverted since the rotational direction of the magnetic field produced by current I flowing in the winding coil 7, to the right of the centre O of the winding coil is opposite to that to the left of the centre O of the winding coil. In Figure 8, the centre O of the winding coil is on one conductive line $S_K$ but the induction signal is not produced on the conductive line $S_K$. The induction signal e is inputted to the phase dectector 12 after it has been amplified by a predetermined factor by the amplification circuit 11 of the signal process circuit 110.

The phase detector 12 has two input terminals, and it outputs a positive polarity signal when one input signal is the same polarity as the other, whereas it outputs a negative polarity signal when one input signal is opposite to the other in polarity.

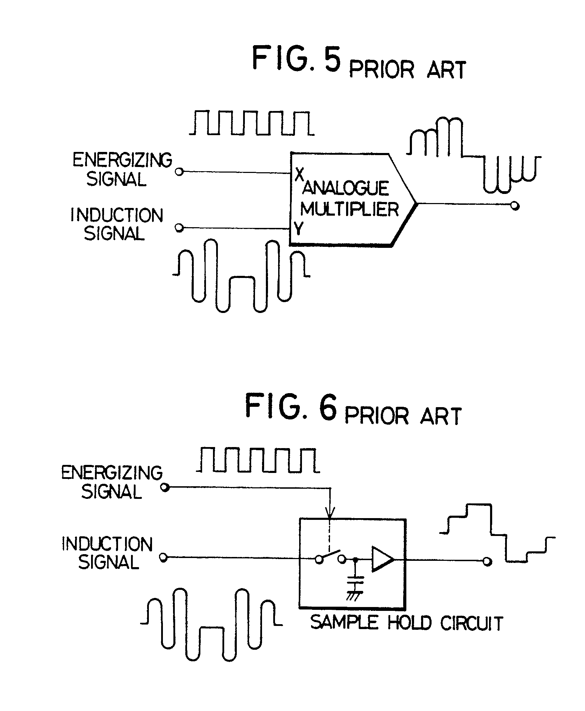

The phase detector of U.S. Patent Specification No. 4,368,351 is embodied by an analogue multiplier shown in Figure 5 and the phase detector of U.S. Patent Specification No. 4,206,314 is embodied by a sample hold circuit shown in Figure 6.

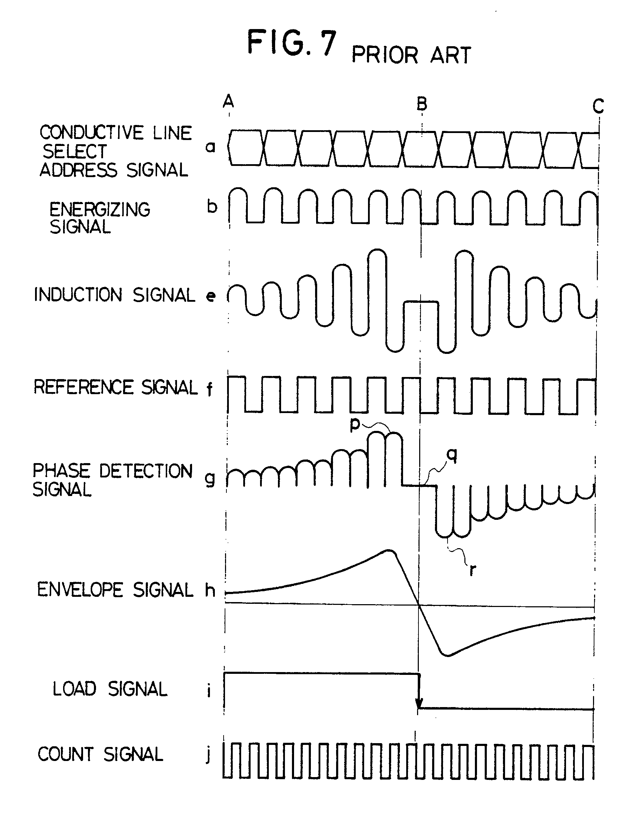

The timing diagram of Figure 7 corresponds to the case where the phase detector is the analogue multiplier of Figure 5 in which the induction signal e is multiplied by the reference signal f equal in phase to the energizing signal b.

A phase detection signal g is applied to the low pass filter 13 which produces an envelope signal h forming an envelope line.

This digitizer adopts a coordinate detection principle in which the induction signal induced on the conductive line at one side of the winding coil is opposite in phase to that of the other side of the winding coil. In accordance with this principle, when the conductive lines are selected in turn, the phase of the induction signal is determined and the conductive line on which phase inversion occurs is detected whereby it may be found that the winding coil is disposed between a pair of conductive lines. This principle is used to detect not only a conductive line adjacent to the winding coil but also to determine the detailed position of the winding coil between adjacent conductive lines.

As shown in Figure 7, signals p, q and r in the neighbourhood of the conductive line on which phase inversion occurs represent an amplitude change dependent on the position of the winding coil so that the polarity inversion point of the envelope signal h changes in dependence on the amplitude change. The position when the polarity of the envelope signal inverts represents the position of the winding coil.

The comparator 14 which receives the envelope signal h, produces the load signal i inverting its polarity when the envelope signal passes O.

From the above principle, the coordinate of the winding coil is determined by measuring the time taken from a count starting point A (which is a scan starting point, coordinate "O" point) to a point B where the load signal i is produced. Although the count of the counter 4 is used to measure this time, the count is also used to count the conductive lines.

In the example of Figure 7, the space between two conductive lines is divided into four by the count signal j because it has 1/4 period of the conductive line select address signal. This means that the coordinates may be determined to an accuracy of 1.6 mm, if the conductive lines are arranged with a spacing of 6.4 mm. It will be appreciated that a count of shorter period may be used in the case of determining the position of the winding coil with greater accuracy.

As mentioned above, this digitizer needs to extract a signal component containing the phase relationship of the induction signal, induced on the conduction lines, relative to the winding coil. To realise this, the conventional digitizer uses an analogue multiplication or sample hold circuit. However, these circuits are relatively complicated and expensive so that it is impossible for such digitisers to be manufactured at low cost.

Digitisers using phase inversion detection make it possible to realise a small size circuit construction but it is desirable to omit or simplify the phase detector since the resulting signal process circuit comprising the amplification circuit, filter and comparator can then be constructed with common circuits.

The present invention seeks to provide a digitiser omitting a phase detector by employing a scanning circuit having a gate function which is turned ON-OFF with a gate signal in synchronism with an energising signal for the winding coil.

According to the present invention there is provided a digitiser comprising: a winding coil for generating a magnetic field to indicate co-ordinate position in response to an energising signal; a substrate having a plurality of conductive lines; detection means for detecting phase inversion of an induction signal induced on said conductive lines; counting means for measuring the time interval between a starting time of selecting one of said conductive lines and a detecting time when phase inversion occurs; a scanning circuit for selecting said conductive lines in turn; and co-ordinate storing means for holding a coordinate value characterised in that said scanning circuit is arranged to receive a gate signal from said counting means at an input terminal with the same frequency as, and in synchronism with said energising signal and includes circuit means for selecting one of said conductive lines only when said gate signal is high corresponding to the detection of half a period of the inductive signal on each conductive line.

Preferably the analog switch means are connected to said circuit means.

Said detecting means may comprise an amplification circuit for amplifying said induction signal, a low pass filter for producing an envelope signal and a comparator for producing a load signal.

In the preferred embodiment said circuit means is a decoder.

The invention is illustrated, merely by way of example, in the accompanying drawings, in which:-

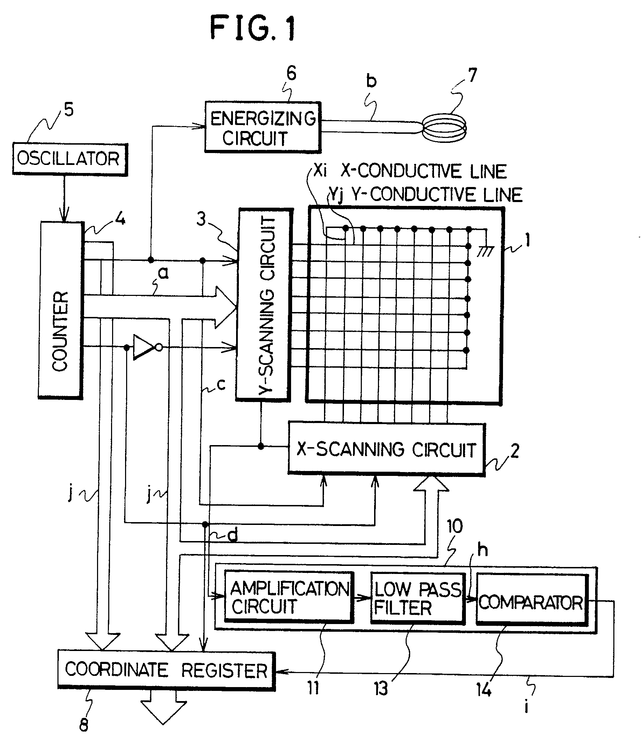

Figure 1 is a block diagram of a digitiser according to the present invention;

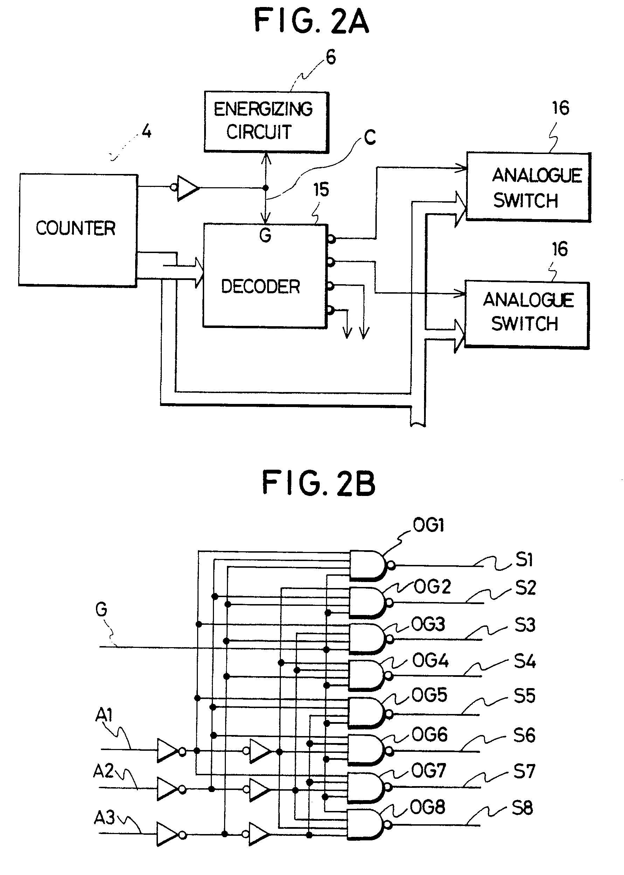

Figure 2A is a detailed block diagram of a scanning circuit of the digitiser of Figure 1;

Figure 2B is a detailed circuit of a decoder shown in Figure 2A;

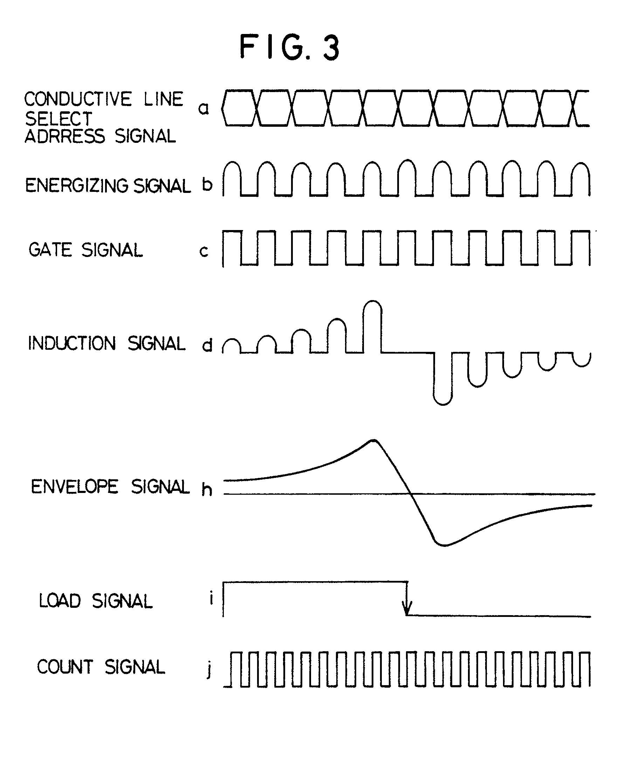

Figure 3 is a timing chart illustrating the operation of the digitizer of Figure 1;

Figure 4 is a block diagram of a conventional digitizer;

Figure 5 is an embodiment of a phase detector of one conventional digitizer;

Figure 6 is an embodiment of a phase detector of another conventional digitizer;

Figure 7 is a timing diagram illustrating the operation of the conventional digitizer of Figures 4 and 5; and

Figure 8 is an explanatory diagram describing the relationship between a signal induced on conductive lines and the position of a winding coil.

Throughout the drawings like parts have been designated by the same reference numerals.

Figure 1 is a block diagram of one embodiment of a digitizer according to the present invention. The digitizer of Figure 1 is different from the conventional digitizer in that a signal process circuit 10, an X-scanning circuit 2 and a Y-scanning circuit 3 are of different construction, but the remaining circuitry may be substantially the same as in the conventional digitizer. As shown in Figure 2A, the X-scanning circuit 2 and the Y-scanning circuit 3 are switch circuits composed of a decoder 15 and analogue switches 16. A conductive line select address signal a and a gate signal c are outputted from a counter 4. The conductive line select address signal is applied to the decoder 15 to control the analogue switches, and the gate signal c is applied to an input terminal G of the decoder 15 and to an energizing circuit 6.

The decoder 15 is shown in greater detail in Figure 2B and has a signal line G for receiving the gate signal c, signal lines $A_1$-$A_3$ for receiving binary data of the conductive line select address signal a and output signal lines $S_1$-$S_8$ for selecting analogue switches 16.

When the conductive line select address signal is applied to the signal lines $A_1$-$A_3$, one of a plurality of output gates $OG_1$-$OG_8$ is selected. At this time, if the gate signal c is applied to the gate signal line G, an analogue switch select signal is produced from one of the output signal lines $S_1$-$S_4$, which corresponds to the conductive line select address.

The analogue switch select signal is not produced when the gate signal is not applied to the gate signal line G, even if the conductive line select address signal is applied to the conductive line select address signal lines $A_1$-$A_3$.

This decoder 15 is embodied by using TTLIC SN74LSl138. The concept of this decoder may be applied to a decoder having a number of conductive line select address signals and a number of analogue switches, although it has been described with reference to Figures 2A and 2B for selecting one of 8 analogue switch select signal lines.

As described above, an additional circuit is not required by using the gate input terminal of the decoder IC, although the gate signal line is set newly in the X-scanning circuit and the Y-scanning circuit in this embodiment of the present invention.

The gate signal c is equal to the reference signal f of the conventional digitizer shown in Figure 4 and the period of the gate signal is half that of the conductive line select address signal a.

The scanning circuit constructed as above is connected to the input terminal of the signal process circuit 10 and selects one of the conductive lines with the conductive line select address signal only while the gate signal is present. The signal process circuit 10 omits the phase detector of the conventional digitizer but comprises the amplification circuit 11, a low pass filter 13 and a comparator 14 as conventional. The signal process circuit receives an induction signal d and outputs the same as a load signal i.

Next, the operation of the digitizer of Figure 1 will be described with reference to Figure 3. As shown in Figure 3, the scanning circuit receives the conductive line select address signal a every given period, the winding coil 7 receives the energizing signal b of one-half period of the conductive line select address signal a, and one of the conductive line or lines produces the induction signal. The scanning circuit receives the gate signal c in synchronism with the energizing signal b and provides the induction signal to the signal process circuit 10 only while the gate signal c is produced so that the induction signal d is inputted to the signal process circuit 10.

The induction signal d corresponds to the phase detection signal g of Figure 7 in the conventional digitizer.

In the prior art, the phase detection signal was formed by full-wave rectification of the induction signal of Figure 7 whereas the induction signal d of Figure 3 is formed by half-wave rectification of the induction signal of Figure 7. It will be appreciated that the induction signal holding its phase relationship relative to the energizing signal b is extracted. Although the phase detector of the conventional analogue multiplier uses both polarity components of the induction signal, the energizing signal b is asymmetric and the induction signal is not symmetric with respect to polarity. The induction signal d obtained by the above described digitizer according to the present invention obtains the envelope line required for the induction signal more conveniently than in the conventional digitizer.

The induction signal d is amplified by a predetermined factor, is converted into an envelope signal h by a low pass filter 13 and thereafter the comparator detects the polarity inversion point to produce the load signal i.

The digitizer described above according to the present invention makes possible the omission of the phase detector from the conventional digitizer since its scanning circuits perform the gate function of the phase detector conventionally employed. Consequently manufacture of a digitizer with a simpler circuit construction becomes possible.

## Claims

1. A digitiser comprising: a winding coil (7) for generating a magnetic field to indicate co-ordinate position in response to an energising signal; a substrate (1) having a plurality of conductive lines ($X_i$, $Y_j$); detection means (10) for detecting phase inversion of an induction signal induced on said conductive lines; counting means (4) for measuring the time interval between a starting time of selecting one of said conductive lines and a detecting time when phase inversion occurs; a scanning circuit (2,3) for selecting said conductive lines in turn; and co-ordinate storing means (8) for holding a co-ordinate value characterised in that said scanning circuit (2,3) is arranged to receive a gate signal (c) from said counting means (4) at an input terminal with the same frequency as, and in synchronism with said energising signal and includes circuit means (15) for selecting one of said conductive lines only when said gate signal is high corresponding to the detection of half a period of the inductive signal on each conductive line.

2. A digitiser as claimed in claim 1 characterised by analog switch means (16) connected to said circuit means (15).

3. A digitiser as claimed in claim 1 or 2 characterised in that said detecting means (10) comprises an amplification circuit (11) for amplifying said induction signal, a low pass filter (13) for producing an envelope signal and a comparator (14) for producing a load signal.

4. A digitiser as claimed in any preceding claim characterised in that said circuit means (15) is a decoder.

## Revendications

1. Convertisseur analogique/numérique comprenant : une bobine (7) pour engendrer un champ magnétique en vue d'indiquer la position des coordonnées, en réponse à un signal d'excitation ; un substrat (1) ayant une pluralité de conducteurs ($X_i$, $Y_j$) ; des moyens de détection (10) pour détecter l'inversion de phase d'un signal inductif induit dans ces conducteurs ; des moyens de comptage (4), pour mesurer l'intervalle de temps entre un temps de démarrage de la sélection de l'un de ces conducteurs et un temps de détection de l'apparition de l'inversion de phase ; un circuit d'exploration (2, 3) pour sélectionner à tour de rôle lesdits conducteurs ; et de moyens de mémorisation (8) pour converser une valeur de coordonnées, caractérisé par le fait que ledit circuit d'exploration (2, 3) est agencé pour recevoir un signal de porte (c) desdits moyens de comptage (4) au niveau d'une borne d'entrée à la même fréquence que et en synchronisme avec ledit signal d'excitation, et comprend des circuits (15) pour sélectionner un desdits conducteurs uniquement lorsque ledit signal de porte est haut, correspondant à la détection d'une demi-période du signal inductif sur chaque conducteur.

2. Convertisseur analogique/numérique selon la revendication 1, caractérisé par des moyens de commutation analogiques (16) reliés auxdits circuits (15).

3. Convertisseur analogique/numérique selon la revendication 1 ou 2, caractérisé par le fait que lesdits moyens de détection (10) comprennent un circuit amplificateur (11) pour amplifier ledit signal inductif, un filtre passe-bas (3) pour produire un signal-enveloppe et un comparateur (14) pour produire un signal de charge.

4. Convertisseur analogique/numérique selon l'une quelconque des revendications précédentes, caractérisé par le fait que ledit circuit (15) est un décodeur.

## Patentansprüche

1. Analog-Digital-Umsetzer mit einer Spule (7) zur Erzeugung eines Magnetfeldes für die Anzeige einer Koordinatenposition in Abhängigkeit von einem Erregersignal, einem Substrat (1) mit einer Vielzahl von Leitern ($X_i$, $Y_j$), einer Detektoranordnung (10) zur Detektierung einer Phaseninversion eines in den Leitern induzierten Induktionssignals, einer Zähleranordnung (4) zur Messung des Zeitintervalls zwischen einer Startzeit eines ausgewählten Leiters und einer Detektionszeit bei Auftreten einer Phaseninversion, einer Abtastschaltung (2, 3) zur Auswahl der Leiter in Folge sowie einer Koordinatenspeicheranordnung (8) zum Halten eines Koordinatenwertes, **dadurch gekennzeichnet,** daß die Abtastschaltung (2, 3) so ausgebildet ist, daß sie ein Tastsignal (c) von der Zähleranordnung (4) an einem Eingangsanschluß aufnimmt, welches die gleiche Frequenz wie das Erregersignal besitzt und synchron mit diesem ist, und daß die Abtastschaltung eine Schaltungsanordnung (15) zur Auswahl einer der Leiter lediglich dann enthält, wenn das Tastsignal entsprechend der Detektierung einer halben Periode des Induktionssignals auf jedem Leiter einen hohen Pegel besitzt.

2. Analog-Digital-Umsetzer nach Anspruch 1, **gekennzeichnet durch** eine mit der Schaltungsanordnung (15) verbundene Analogschalteranordnung (16).

3. Analog-Digital-Umsetzer nach Anspruch 1 oder 2, **dadurch gekennzeichnet,** daß die Detektoranordnung (10) eine Verstärkerschaltung (11) zur Verstärkung des Induktionssignals, ein Tiefpaßfilter (13) zur Erzeugung eines Hüllkurvensignals und einen Komparator (14) zur Erzeugung eines Lastsignals umfaßt.

4. Analog-Digital-Umsetzer nach den vorhergehenden Ansprüchen, **dadurch gekennzeichnet,** daß die Schaltungsanordnung (15) ein Decoder ist.

# FIG.1

# FIG. 2A

ENERGIZING CIRCUIT — 6

COUNTER — 4

C

15

G

DECODER

ANALOGUE SWITCH — 16

ANALOGUE SWITCH — 16

# FIG. 2B

OG1 — S1
OG2 — S2
G
OG3 — S3
OG4 — S4
A1
OG5 — S5
A2
OG6 — S6
A3
OG7 — S7
OG8 — S8

# FIG. 3

CONDUCTIVE LINE SELECT ADRRESS SIGNAL   a

ENERGIZING SIGNAL   b

GATE SIGNAL   c

INDUCTION SIGNAL   d

ENVELOPE SIGNAL   h

LOAD SIGNAL   i

COUNT SIGNAL   j

# FIG.4 PRIOR ART

# FIG. 5 PRIOR ART

ENERGIZING
SIGNAL

INDUCTION
SIGNAL

X
ANALOGUE
MULTIPLIER
Y

# FIG. 6 PRIOR ART

ENERGIZING
SIGNAL

INDUCTION
SIGNAL

SAMPLE HOLD CIRCUIT

# FIG. 7 PRIOR ART

# FIG. 8